# EUROPEAN PATENT APPLICATION

(11) **EP 1 801 873 A1**
(43) Date of publication of application: **27.06.2007**
(21) Application number: 05790544.0
(22) Date of filing: 05.10.2005
(51) Int. Cl.: H01L 23/29, H01L 21/56

(54) **HIGH WITHSTAND VOLTAGE SEMICONDUCTOR DEVICE COVERED WITH RESIN AND PROCESS FOR PRODUCING THE SAME**

(30) Priority: 06.10.2004 JP 2004293873
(71) Applicant: THE KANSAI ELECTRIC POWER CO., INC., Osaka-shi, Osaka 530-8270 (JP); Adeka Corporation, Tokyo 116-0012 (JP)
(72) Inventor: OKADA, Shinichi, KANSAI ELECTRIC POWER CO. INC., Osaka-shi, Osaka 5308270 (JP); SUGAWARA, Yoshitaka, KANSAI ELECTRIC POWER CO. INC, Osaka-shi, Osaka 5308270 (JP); ASANO, Katsunori, KANSAI ELECTRIC POWER CO. INC., Osaka-shi, Osaka 5308270 (JP); TAKAYAMA, Daisuke, KANSAI ELECTRIC POWER CO. INC., Osaka-shi, Osaka 5308270 (JP); SHOJI, Yoshikazu, ASAHI DENKA Co. Ltd., Tokyo 1160012 (JP); JANADO, Tadashi, ASAHI DENKA Co. Ltd., Tokyo 1160012 (JP); SUEYOSHI, Takashi, ASAHI DENKA Co. Ltd., Tokyo 1160012 (JP); HIWATARI, Ken-ichiro, ASAHI DENKA Co. Ltd., Tokyo 1160012 (JP)
(74) Representative: Suckling, Andrew Michael
(86) International application number: PCT/JP2005/018420
(87) International publication number: WO 2006/038644

(57) **Abstract**

A high withstand voltage semiconductor chip mounted on a package or a board is covered with a sealing resin, and the resin is cured while a high voltage is applied between at least one of electrode terminals connected from a chip electrode or the chip via wiring of wires or the like and another electrode that necessitates a dielectric withstand voltage between the electrode and the electrode terminal during the curing. The sealing resin is provided by a synthetic high molecular compound structured in a manner that an organic silicon polymer C is constituted by alternately linearly linking an organic silicon polymer A having a crosslinking structure of siloxane with an organic silicon polymer B having a linear link structure of siloxane (Si-O-Si bond) by siloxane bond and the polymers are three-dimensionally linked together by covalent bond. With this arrangement, a dielectric withstand voltage capability, which is stable by suppression of an increase in the leakage current even when a high reverse voltage is applied and agrees with the designed value, can be obtained in a high withstand voltage semiconductor chip that is mounted on a board or a package and sealed with the resin.

## Description

### TECHNICAL FIELD

The present invention relates to a semiconductor device whose withstand voltage is raised by covering a high withstand voltage semiconductor element with a resin.

### BACKGROUND ART

A wide-gap semiconductor material made of silicon carbide (hereinafter referred to as SiC) or the like has excellent physical properties of a larger energy gap and a dielectric breakdown field intensity of about an order of magnitude greater than those of silicon (hereinafter referred to as Si) and attracts attention as a semiconductor material suitable for use in semiconductor devices of high heat resistance and high withstand voltage.

In the case of a conventional high withstand voltage semiconductor device employing SiC, a SiC semiconductor element having a high reverse breakdown voltage is housed in a metallic package. In order to improve the dielectric breakdown strength of space between electrodes of the SiC semiconductor element to which a high voltage is applied, the package is filled with an insulating gas such as sulfur hexafluoride gas.

The sulfur hexafluoride gas, which currently has a most excellent insulating property as an insulating gas, needs to be avoided from use from the viewpoint of preventing global warming since it contains fluorine, or a substance that destroys the ozone layer.

As a method for maintaining the excellent insulating property other than the filling of the sulfur hexafluoride gas, there is a method for covering the semiconductor element with a synthetic high molecular compound (generally called silicone rubber) that contains polymethyl phenyl siloxane having a linear structure of siloxane (Si-O-Si bond) or a synthetic high molecular compound that contains polyphnyl silsesquioxane having a crosslinking structure of siloxane. The synthetic high molecular compound is applied to cover the entire semiconductor element (semiconductor chip) in a liquid state of high viscosity and cured at a normal temperature or by heating to a temperature of about 100°C to 200°C. As a result, a comparatively high insulating property can be maintained.
First patent document: JP 2002-356617 A
Second patent document: JP 2000-198930 A

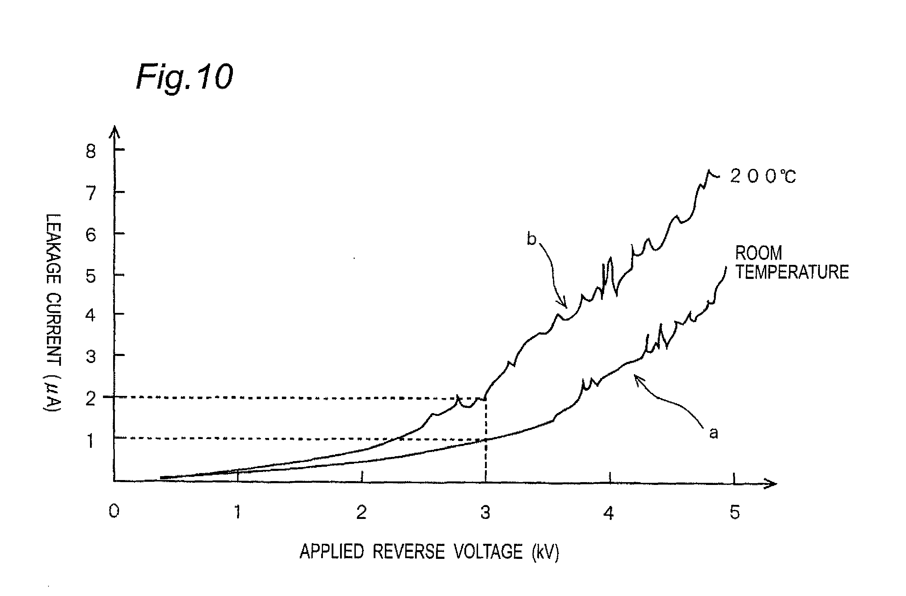

In a semiconductor device of a rating of 5 kV having a cover obtained by applying a liquid high molecular compound of the silicone rubber or the like and curing the compound, or, for example, a diode, when a reverse voltage of 3 kV to 5kV is applied between the anode electrode and the cathode electrode, a large leakage current of 2 µA to 8 µA flows between both electrodes as shown in FIG. 10. When the applied reverse voltage is 3 kV, the leakage current, which has been 1 µA at the room temperature as indicated by a curve "a" increases to 2 µA as indicated by a curve "b" when the temperature of the semiconductor device is at 200°C. Moreover, when a reverse voltage of not lower than 3.5 kV at the room temperature or a reverse voltage of not lower than 2.5 kV at 200°C is applied, the leakage current is varied by the applied reverse voltage as indicated by the fluctuations of the curves "a" and "b", and the insulation becomes unstable. Therefore, the prescribed reverse breakdown voltage characteristic estimated in the designing stage is sometimes not obtained. The present inventors have conducted various experiments, analyses and investigations on the cause of the above phenomenon. As a result, it was discovered that the orientation direction of molecules became irregular when the liquid high molecular compound was cured and this possibly caused a local nonuniformity in the structure of the high molecular compound after curing. It is considered that, if there is such a structural nonuniformity, the electrical resistance is reduced by an electric field generated when the reverse voltage is applied, and a leakage current flows.

### DISCLOSURE OF THE INVENTION

It is an object of the present invention to provide a high withstand voltage semiconductor device in which a semiconductor element that constitutes the semiconductor device is covered with a material having a high withstand voltage.

In order to achieve the above object, there is provided a high withstand voltage semiconductor device comprising:
a high withstand voltage semiconductor element having at least two electrodes between which a high withstand voltage is necessitated;
a first lead wire connected to one of at least the two electrodes;
a second lead wire connected to the other of at least the two electrodes; and
a resin coating material that is applied to cover the high withstand voltage semiconductor element, the electrodes and neighborhoods of connection portions of the first and second lead wires to the electrodes and is cured while a prescribed DC voltage is applied between the first and the second lead wires.

According to the present invention, an electric field is applied to the uncured resin by applying a DC voltage between at least two electrodes covered with the uncured resin. The inventor supposes that the molecules of the uncured resin are oriented in the direction of the electric field by the electric field, aligning the orientation direction, and the dielectric constant of the resin and the DC resistance are increased by curing the resin in a state in which the orientation direction is aligned. However, no theoretical analysis has been made at the present time. At any rate, the leakage current is reduced according to the actually measured results.

Also, there is provided a method for manufacturing a high withstand voltage semiconductor device including:
a high withstand voltage semiconductor element having at least two electrodes between which a high withstand voltage is required,
a first lead wire connected to one of at least the two electrodes, and
a second lead wire connected to the other of at least the two electrodes, wherein
the method comprises the steps of:
   applying a resin to cover the high withstand voltage semiconductor element, the electrodes and neighborhoods of connection portions of the first and second lead wires to the electrodes; and
   curing the resin while a prescribed DC voltage is applied between the first and second lead wires.

According to the present invention, the high molecular compound after being cured is softened by heating. By applying an electric field to the softened high molecular compound, the molecules of the high molecular compound are oriented in a definite direction. If the temperature is set back to the normal temperature in the above state, the orientation direction of the molecules is fixed in the definite direction. As a result, the resistance of the high molecular compound is maintained at a maximum value.

Also, there is provided a method for manufacturing a high withstand voltage semiconductor device including:
a high withstand voltage semiconductor element having at least two electrodes between which a high withstand voltage is necessitated,
a first lead wire connected to one of at least the two electrodes, and
a second lead wire connected to the other of at least the two electrodes, wherein
the method comprises the steps of:
   applying a resin to cover the high withstand voltage semiconductor element, the electrodes and neighborhoods of connection portions of the first and second lead wires to the electrodes and curing the resin; and
   heating the resin to a prescribed temperature while a prescribed DC voltage is applied between the first and second lead wires.

According to the present invention, by applying the resin to cover the semiconductor element and curing the resin while a prescribed reverse voltage is applied between at least two electrodes that necessitate a high withstand voltage of the semiconductor element, the reverse withstand voltage between at least the two electrodes can be raised. Moreover, after the resin has cured, by carrying out heating while the prescribed reverse voltage is applied between the two electrodes, an effect similar to the above can be obtained.

### BRIEF DESCRIPTION OF THE DRAWINGS

FIG. 1 is a sectional view of a high withstand voltage SiC diode device according to a first embodiment of the present invention;
FIG. 2 is a circuit diagram of a method for manufacturing the high withstand voltage SiC diode device of the first embodiment of the present invention;
FIG. 3 is a graph showing measurement results of the high withstand voltage SiC diode device of the first embodiment of the present invention compared with a conventional example;
FIG. 4 is a graph showing a relation between an applied reverse voltage and a leakage current measured by changing the temperature of the SiC diode device of the first embodiment of the present invention;
FIG. 5 is a sectional view of a high withstand voltage SiC diode device of another example of the first embodiment of the present invention;
FIG. 6 is a sectional view of a high withstand voltage SiC diode device of a yet another example of the first embodiment of the present invention;
FIG. 7 is a sectional view of a high withstand voltage SiC diode device of a yet another example of the first embodiment of the present invention;
FIG. 8 is a graph showing a relation between the time and the leakage current of voltage application at high temperature of a high withstand voltage SiC diode device according to a second embodiment of the present invention;
FIG. 9 is a graph showing a comparison between leakage currents obtained before and after the voltage application at high temperature of the second embodiment of the present invention; and
FIG. 10 is a graph showing a relation between the applied reverse voltage and the leakage current of a conventional SiC diode device.

### EXPLANATION OF REFERENCE NUMERALS:

- 1: board
- 2: SiC diode element
- 4: anode electrode
- 5: anode terminal
- 6: cathode electrode
- 7: cathode terminal
- 8: insulating material
- 9, 16, 18: resin
- 10: heating furnace
- 11: DC power source
- 12, 13, 14: SiC diode device
- 20: printed circuit board
- 21, 22: circuit conductor

### DETAILED DESCRIPTION OF THE INVENTION

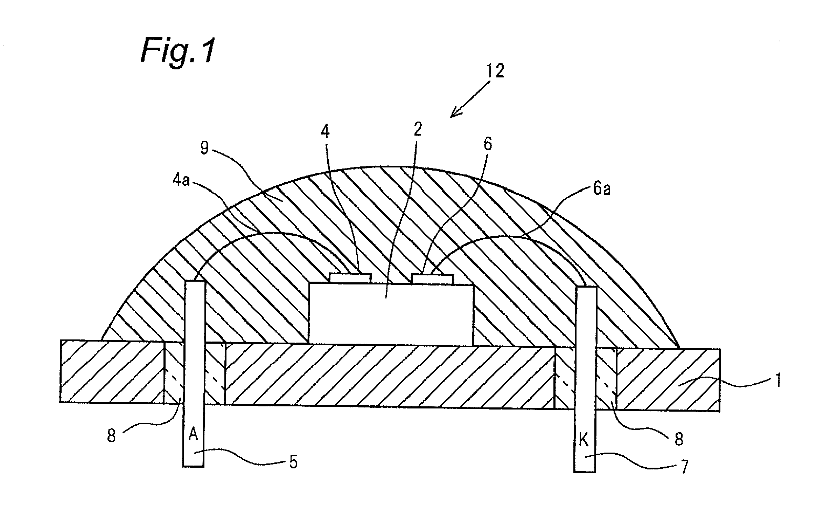

High withstand voltage semiconductor devices and manufacturing methods therefor of preferred embodiments of the present invention will be described with reference to FIGS. 1 through 9.

### THE FIRST EMBODIMENT

The high withstand voltage semiconductor device and the manufacturing method therefor according to the first embodiment of the present invention are described with reference to FIGS. 1 through 7.

FIG. 1 is a sectional view of a high withstand voltage SiC diode device having a withstand voltage of 5 kV, which is the high withstand voltage semiconductor device of the first embodiment of the present invention. In FIG. 1, an SiC diode element (chip) 2 is bonded to a center portion of a metal board 1, which constitutes a package, with a high temperature solder or the like. An anode electrode 4 of the SiC diode element 2 is connected to an anode terminal 5 via a lead wire 4a. A cathode electrode 6 of the SiC diode element 2 is connected to a cathode terminal 7 via a lead wire 6a. The anode terminal 5 and the cathode terminal 7 are insulated from the metal board 1 by an insulating material 8 of glass or the like.

A thermosetting sealing resin 9 is applied to cover the SiC diode element 2, the lead wires 4a and 6a, the anode terminal 5 and the cathode terminal 7, which are constituted on the metal board 1 as described above and protruding from the upper surface of the metal board 1. The viscosity of the resin 9 is selected to an appropriate value so that the coating layer is mounded in a mountain-like shape as shown in FIG. 1 and no void is internally generated. If the viscosity is extremely low, the coating layer is not mounded in a mountain-like shape, so that the lead wires 4a and 6a jut out of the coating layer or the thickness of the resin 9 that covers the surface of the SiC diode element 2 becomes thin. Moreover, if the viscosity is extremely high, voids are sometimes internally generated.

A general thermosetting resin can be used as the resin 9. Epoxy resin is an example of the thermosetting resin. More preferable resins include the following three resins.
1. A synthetic high molecular compound constituted of polydimethylsiloxane having a linear structure of siloxane (Si-O-Si bond) called Si rubber.
2. A synthetic high molecular compound constituted of polyphenyl silsesquioxane having a crosslinking structure of siloxane.
3. A synthetic high molecular compound structured in a manner that an organic silicon polymer C is constituted by alternately linearly linking an organic silicon polymer A having a crosslinking structure of siloxane with an organic silicon polymer B having a linear link structure of siloxane (Si-O-Si bond) by siloxane bond, and the organic silicon polymers C are three-dimensionally linked together by covalent bond generated by addition reaction.

The above synthetic high molecular compounds each have a good heat resistance and are able to be used by combining any one or a plurality of them.

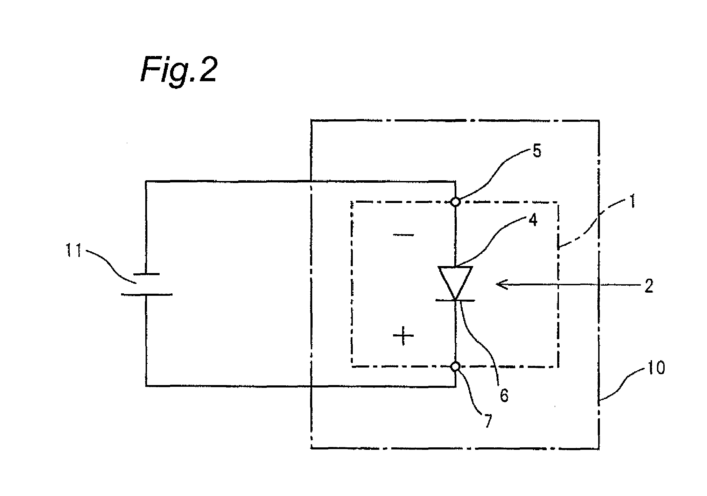

The board 1 covered with the sealing resin 9 is put in a heating furnace 10 such as an electric furnace as shown in the schematic view of FIG. 2. The anode terminal 5 and the cathode terminal 7 are connected to the negative terminal and the positive terminal, respectively, of a DC power source 11 (voltage: 1 kV), and a reverse voltage of 1 kV is applied to the SiC diode 2. It is proper to determine an appropriate value of the reverse voltage within a range of 100 V to 5 kV by experiments according to the kind of the resin, a distance between the anode terminal 5 and the cathode terminal 7 and so on. In the above state, the temperature of the heating furnace 10 is raised to 200°C and heated for about five hours (curing time). After a lapse of the curing time, slow cooling is performed to the room temperature. The slow cooling time was set to about three hours. The temperature of the heating furnace 10 is selected between about 30°C and 300°C according to the kind of the resin.

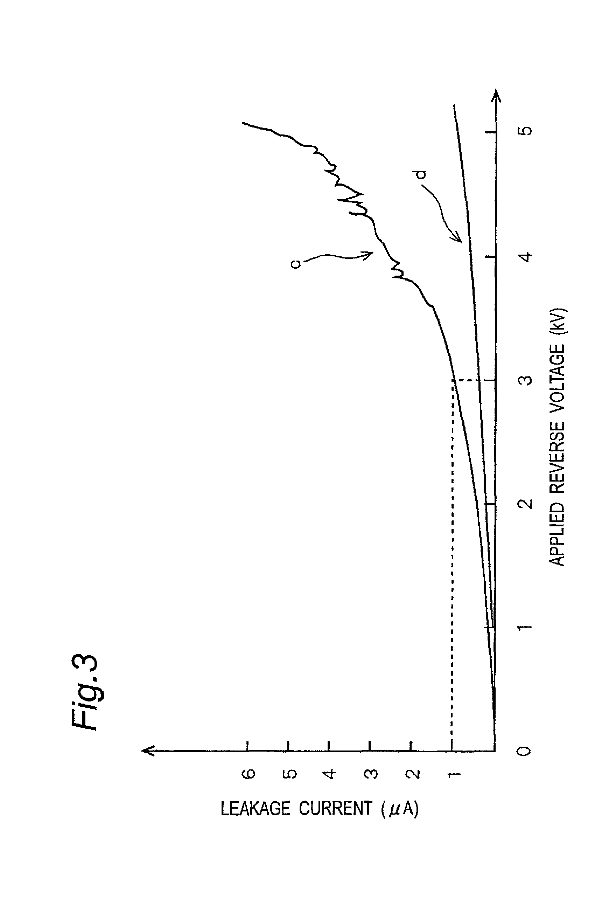

A reverse voltage of 0 V to 5 kV was applied between the anode terminal 5 and the cathode terminal 7 of the thus-obtained SiC diode device 12 at the room temperature, and a leakage current between the anode terminal 5 and the cathode terminal 7 was measured. The result is shown in FIG. 3. In FIG. 3, the horizontal axis represents the applied reverse voltage (kV), and the vertical axis represents the leakage current (µA). A curve "c" in FIG. 3 is almost the same as the curve "a" in FIG. 10 described in the paragraph of the background art. This shows the measurement data of a sample that has been cured without applying the reverse voltage between the anode terminal 5 and the cathode terminal 7 of the SiC semiconductor device 12 for the sake of comparison with the SiC semiconductor device 12 of the present embodiment.

A curve "d" in FIG. 3 represents the measurement result of the SiC semiconductor device 12 of the present embodiment at the room temperature. If the curve "c" and the curve "d" are compared with each other when the applied reverse voltage is 3 kV, the leakage current is 0.3 µA or reduced to about one third in the curve "d" in contrast to the leakage current of 1 µA in the curve "c". Moreover, when the applied reverse voltage was 5 kV, the leakage current had a small value of about 1 µA in the curve "d" in contrast to the leakage current that was largely increased to about 6 µA in the curve "c". Moreover, the curve "d" is very smooth without fluctuations like those of the curve "c". It can be understood from this point that the value of the leakage current stably changes with respect to the applied reverse voltage in the SiC diode device 12 of the present embodiment.

The leakage current does not increase so much in the SiC diode device 12 of the present embodiment even when a high reverse voltage is applied. Therefore, a high withstand voltage characteristic can be maintained.

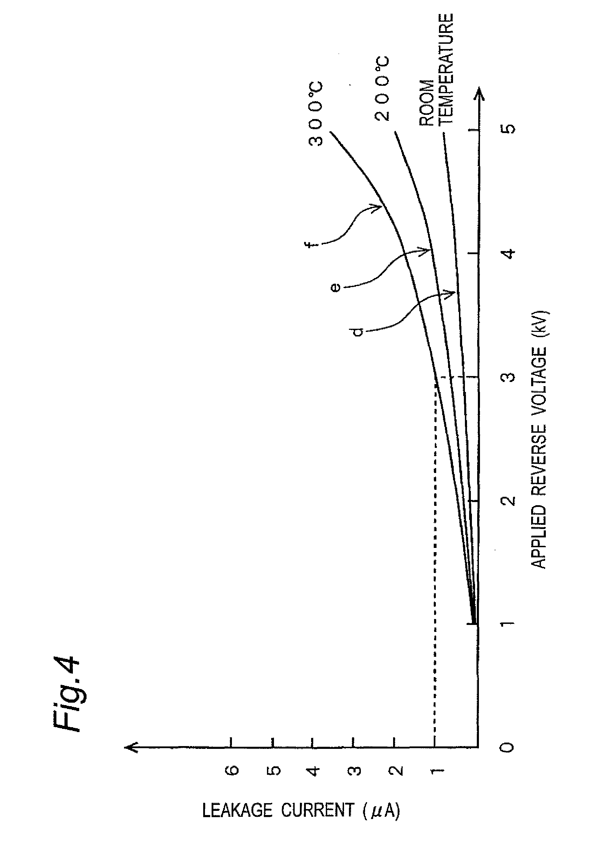

FIG. 4 shows the result of measuring the leakage current by raising the temperature of the SiC diode device 12 of the present embodiment. In FIG. 4, a curve "d" represents the measurement result at the room temperature, and it is the same as the curve "d" in FIG. 3. A curve "e" in FIG. 4 represents the measurement result at a temperature of 200°C, and a curve "f" represents the measurement result at a temperature of 300°C. During the measurement, the SiC diode device 12 of the present embodiment was put in a heating furnace and maintained at each prescribed temperature.

As is apparent from FIG. 4, when the applied reverse voltage was 3 kV, the leakage current at the room temperature was about 0.3 µA, the leakage current at 200°C was about 0.6 µA, and the leakage current at 300°C was about 1.0 µA. If the curve "e" in FIG. 4 is compared with the curve "b" in FIG. 10 of the conventional device at the same temperature of 200°C, it can be understood that the leakage current of the SiC diode device 12 of the present embodiment when the reverse voltage is 5 kV is 2 µA, which is remarkably small in comparison with the leakage current of 8 µA of the SiC diode device of the conventional example when the reverse voltage is 5 kV.

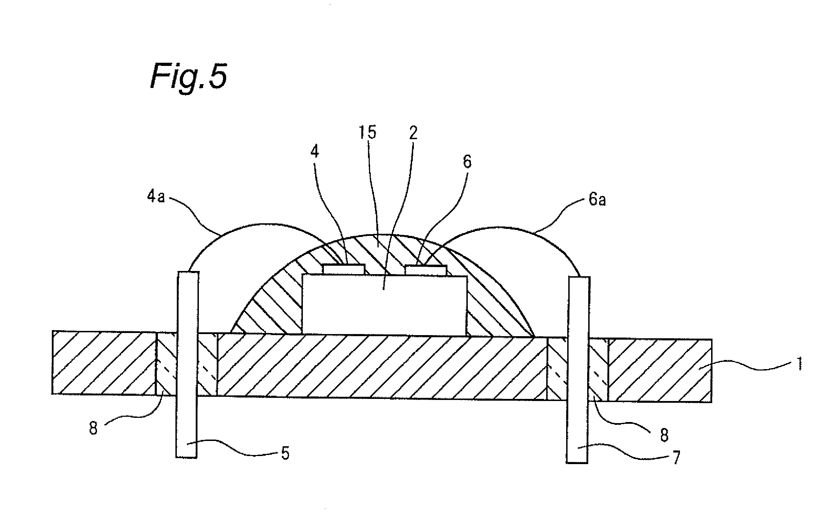

In the SiC diode device of the present embodiment as shown in FIG. 1, it is most preferable to cover all of the SiC diode element 2, the lead wires 4a and 6a, the anode terminal 5 and the cathode terminal 7, which are protruding outwardly of the board 1, with the resin 9. However, in order to simplify the construction, the effect of the present invention can be obtained to some extent with a construction in which the SiC diode element 2 and parts of the lead wires 4a and 6a are covered with a resin 15 as shown in FIG. 5.

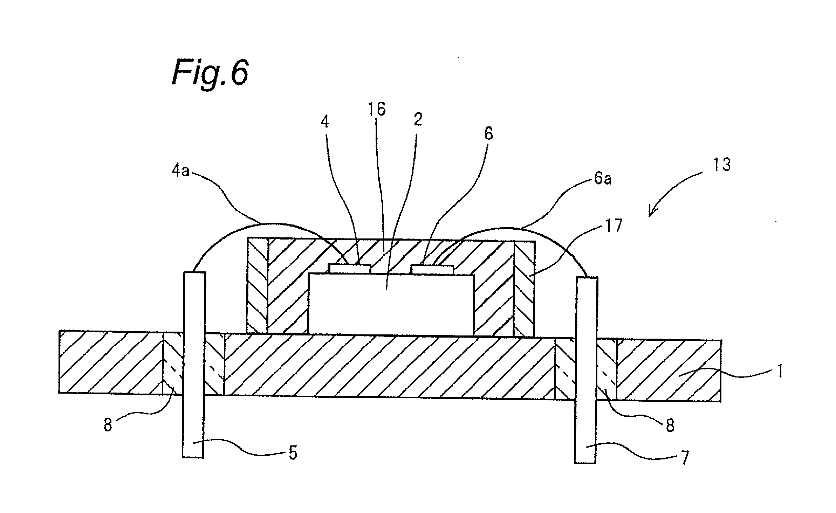

FIG. 6 is a sectional view of the SiC diode device of another example of the present embodiment. In the SiC diode device 13 shown in FIG. 6, a frame 17 that is made of a metal or a heat resistant resin and has a size sufficient for enclosing the periphery of the SiC diode element 2 on the board 1 is provided. The SiC diode element 2 is positioned in a center portion of the frame 17 and bonded to the board 1 with high temperature solder or the like. The anode electrode 4 of the SiC diode element 2 is connected to the anode terminal 5 via the lead wire 4a, and the cathode electrode 6 is connected to the cathode terminal 7 via the lead wire 6a. A resin 16 is poured into the frame 17 and cured by heating while a reverse voltage is applied between the anode terminal 5 and the anode terminal 7 as shown in FIG. 2.

In the example shown in FIG. 6, a resin of low viscosity can be used as the resin 16 because of the provision of the frame 17. If a resin of low viscosity is used, voids and the like scarcely enter the inside of the resin 16. Since the insulating property might be reduced when voids enter, it is preferred to prevent the entry of voids as far as possible.

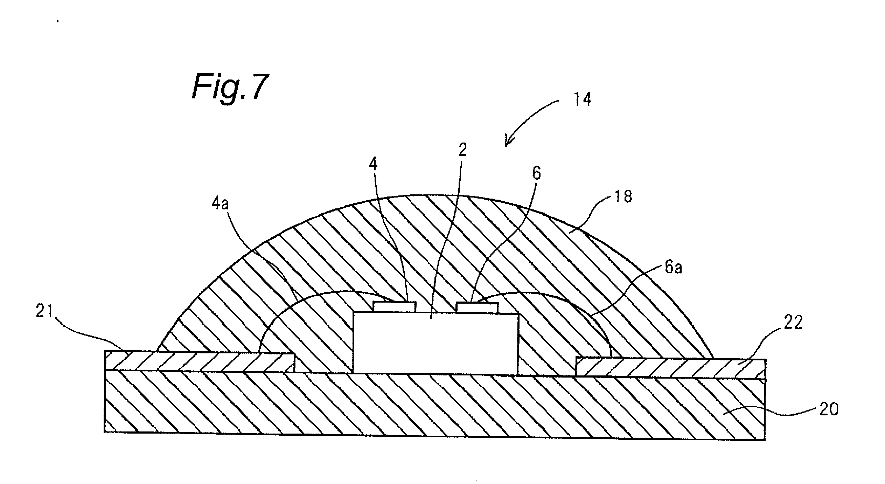

FIG. 7 is a sectional view of a SiC diode device 14 of another example of the present embodiment. The example shown in FIG. 7 shows a case where the SiC diode element 2 is mounted on a printed wiring board 20. In the figure, the SiC diode element 2 is bonded to the wiring board 20 of an insulator with a heat resistant adhesive. The anode electrode 4 of the SiC diode 2 is connected to a circuit conductor 21 of a prescribed wiring pattern via the lead wire 4a, and the cathode electrode 6 is connected to a circuit conductor 22 via the lead wire 6a. A resin 18 is applied to cover the SiC diode element 2, the lead wires 4a and 6a, and regions that include the connection portions of the lead wires 4a and 6a and the respective circuit conductors 21 and 22. Next, the resin 18 is cured at the normal temperature or a prescribed high temperature by heating while a reverse voltage is applied to the SiC diode element 2 by connecting the circuit conductors 21 and 22 to the DC power source 11 as in the device shown in FIG. 2. The other constructions and operative effects are similar to those of the device shown in FIG. 1.

Although the examples each employing the SiC diode element 2 as a semiconductor element have been described in connection with the semiconductor devices of FIGS. 1 through 7 of the present embodiment, the present invention is not limited to the SiC diode element 2 but applicable to all sorts of semiconductor devices such as bipolar elements of IGBT and GTO, FET other than the bipolar elements and so on. In the semiconductor element having three or more terminals such as a bipolar transistor or FET, the resin is cured by heating to a prescribed high temperature while two terminals between which the highest possible reverse voltage is applied are connected to the D. power source 11 and a reverse voltage is applied as shown in FIG. 2.

Although the method for heating the resins 9, 15, 16 and 18 to a temperature of about 200°C when the resins are cured has been described in the present embodiment, it is acceptable to perform the curing at a temperature of not higher than 200°C or at the normal temperature depending on the kind of the resin.

### THE SECOND EMBODIMENT

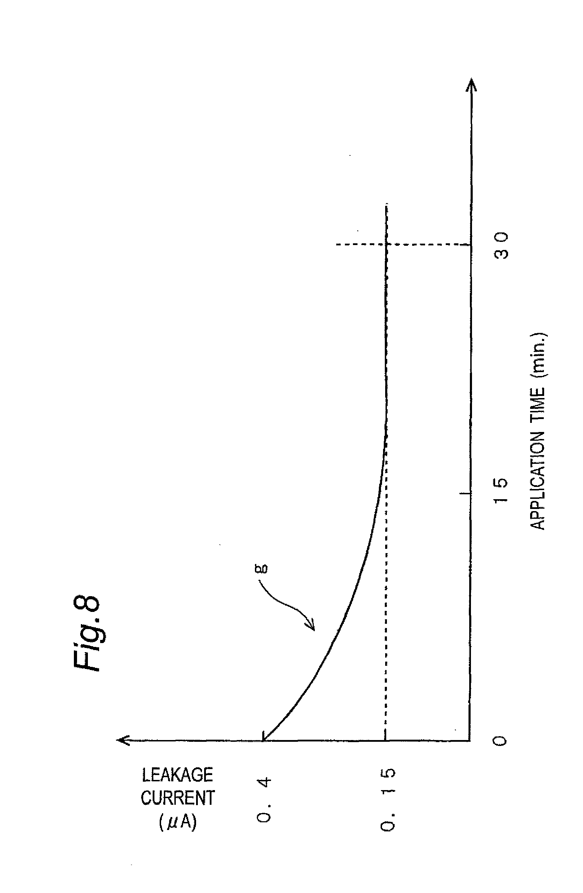

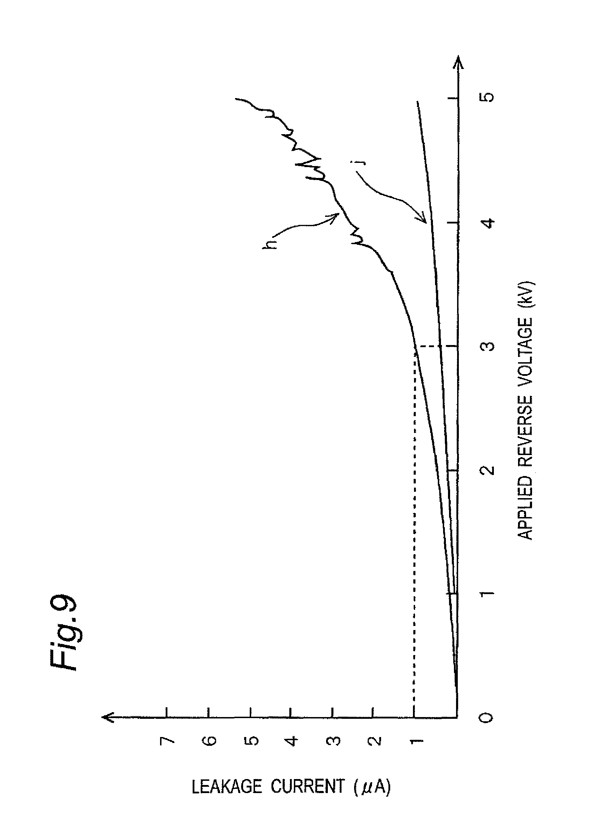

A high withstand voltage semiconductor device and a manufacturing method therefor of the second embodiment of the present invention are described with reference to FIGS. 8 and 9. According to the manufacturing method of the second embodiment, no high voltage is applied between the electrodes during the curing process of the sealing resin 9 described in the first embodiment.

If the present embodiment is described referring to, for example, FIG. 1, the sealing resin 9 is applied to cover the semiconductor element 2, the lead wires 4a and 6a, the anode terminal 5 and the cathode terminal 7, which are protruding from the upper surface of the metal board 1, and cured as it is. The resin 9 is provided by a synthetic high molecular compound structured in a manner that an organic silicon polymer C is constituted by alternately linearly linking epoxy based resin or an organic silicon polymer A having a crosslinking structure of siloxane with an organic silicon polymer B having a linear link structure of siloxane (Si-O-Si bond) by siloxane bond, and the organic silicon polymers C are three-dimensionally linked together by covalent bond generated by addition reaction. A high withstand voltage SiC diode 2 is employed as the semiconductor element 2. After curing the resin 9, the SiC diode device 12 is heated to a temperature of, for example, about 200°C while a reverse voltage of 1 kV is applied between the anode terminal 5 and the cathode terminal 7 with the construction shown in FIG. 2. The above processing is hereinafter referred to as "voltage application at high temperature". It is proper to determine the time of the voltage application at high temperature within a range of about ten minutes to two hours according to the kinds of the semiconductor element 2 and the sealing resin 9. It is also proper to arbitrarily select the applied reverse voltage within a range of 100 V to 5 kV.

FIG. 8 is a graph showing a relation between the processing time of the voltage application at high temperature and a leakage current after the processing is carried out according to the manufacturing method of the SiC diode device 12 of the present embodiment. In order to measure the leakage current, an ammeter (not shown) is connected between the DC power source 11 and the anode terminal 5 of FIG. 2. The SiC diode device 12 was put in a heating furnace and heated to a temperature of 200°C while a reverse voltage of 1 kV is applied between the anode terminal 5 and the cathode terminal 7. It was discovered that the leakage current at the time of starting the voltage application at high temperature was about 0.4 µA, and the leakage current was gradually reduced as indicated by a curve "g" when the time of the voltage application at high temperature became long. The leakage current became about 0.15 µA after a lapse of 30 minutes, and the current was subsequently scarcely reduced.

FIG. 9 is a graph showing the characteristic when the reverse voltage is applied between the anode terminal 5 and the cathode terminal 7 before and after the SiC diode device 12 is subjected to the voltage application at high temperature. The leakage current is about 1 µA when the applied reverse voltage is 3 kV before the voltage application at high temperature as indicated by a curve "h", and the leakage current fluctuates according to the applied reverse voltage and becomes unstable when the applied reverse voltage becomes 3.5 kV or higher. A curve "j" represents the characteristic when the reverse voltage is applied after the voltage application at high temperature is carried out for 30 minutes. The leakage current at an applied reverse voltage of 3 kV was not greater than 0.3 µA, which was a sufficiently small value. Moreover, there was almost no fluctuation in the leakage current when the applied reverse voltage changed, and an excellent reverse voltage application characteristic was able to be obtained. According to the experiments conducted by the inventor, it was discovered that the effect of reducing the leakage current was higher as the applied reverse voltage and the temperature during the voltage application at high temperature were higher. The reduction in the leakage current due to the voltage application at high temperature is presumably ascribed to the following operation. A very small amount of ions is contained in the cured resin before the voltage application at high temperature, and leakage current flows when a voltage is applied between the anode and the cathode. The viscosity of the resin is reduced by raising the temperature of the cured resin, and when the voltage application is carried out in the state, the ions in the resin gather to the electrode of the polarity opposite to that being charged on themselves and fixed as they are when the resin is cooled. Consequently, ions that can move in the resin are almost lost, and the leakage current is reduced.

### INDUSTRIAL APPLICABILITY

The present invention can be utilized for resin sealed type high withstand voltage semiconductor devices.

## Claims

1. A high withstand voltage semiconductor device comprising:
a high withstand voltage semiconductor element having at least two electrodes between which a high withstand voltage is necessitated;
a first lead wire connected to one of at least the two electrodes;
a second lead wire connected to the other of at least the two electrodes; and
a resin coating material that is applied to cover the high withstand voltage semiconductor element, the electrodes and neighborhoods of connection portions of the first and second lead wires to the electrodes and is cured while a prescribed DC voltage is applied between the first and the second lead wires.

2. The high withstand voltage semiconductor device as claimed in claim 1, wherein
the resin contains at least one selected from a group consisting of: a synthetic high molecular compound constituted of polydimethylsiloxane having a linear structure of siloxane (Si-O-Si bond) called Si rubber; a synthetic high molecular compound constituted of polyphenyl silsesquioxane having a crosslinking structure of siloxane; and a synthetic high molecular compound structured in a manner that an organic silicon polymer C is constituted by alternately linearly linking an organic silicon polymer A having a crosslinking structure of siloxane with an organic silicon polymer B having a linear link structure of siloxane (Si-O-Si bond) by siloxane bond, and the organic silicon polymers C are three-dimensionally linked together by covalent bond generated by addition reaction.

3. The high withstand voltage semiconductor device as claimed in claim 1, wherein
the DC voltage is within a range of 100 V to 5 kV.

4. A method for manufacturing a high withstand voltage semiconductor device including:
a high withstand voltage semiconductor element having at least two electrodes between which a high withstand voltage is required,
a first lead wire connected to one of at least the two electrodes, and
a second lead wire connected to the other of at least the two electrodes, wherein
the method comprises the steps of:
applying a resin to cover the high withstand voltage semiconductor element, the electrodes and neighborhoods of connection portions of the first and second lead wires to the electrodes; and
curing the resin while a prescribed DC voltage is applied between the first and second lead wires.

5. A method for manufacturing a high withstand voltage semiconductor device including:
a high withstand voltage semiconductor element having at least two electrodes between which a high withstand voltage is necessitated,
a first lead wire connected to one of at least the two electrodes, and
a second lead wire connected to the other of at least the two electrodes, wherein
the method comprises the steps of:
applying a resin to cover the high withstand voltage semiconductor element, the electrodes and neighborhoods of connection portions of the first and second lead wires to the electrodes and curing the resin; and
heating the resin to a prescribed temperature while a prescribed DC voltage is applied between the first and second lead wires.

6. The high withstand voltage semiconductor device manufacturing method as claimed in claim 4 or 5, wherein
the resin contains at least one selected from a group consisting of: a synthetic high molecular compound constituted of polydimethylsiloxane having a linear structure of siloxane (Si-O-Si bond) called Si rubber; a synthetic high molecular compound constituted of polyphenyl silsesquioxane having a crosslinking structure of siloxane; and a synthetic high molecular compound structured in a manner that an organic silicon polymer C is constituted by alternately linearly linking an organic silicon polymer A having a crosslinking structure of siloxane with an organic silicon polymer B having a linear link structure of siloxane (Si-O-Si bond) by siloxane bond, and the organic silicon polymers C are three-dimensionally linked together by covalent bond generated by addition reaction.

7. The high withstand voltage semiconductor device manufacturing method as claimed in any one of claims 4 through 6, wherein
the DC voltage is within a range of 100 V to 5 kV.

8. The high withstand voltage semiconductor device manufacturing method as claimed in claim 5, wherein
a temperature of the heating is 30°C to 300°C.
